# EUROPEAN PATENT APPLICATION

(11) **EP 0 623 688 A1**
(43) Date of publication of application: **09.11.1994**
(21) Application number: 93303462.1
(22) Date of filing: 04.05.1993
(51) Int. Cl.: C23C 14/04, C23C 16/04, B05B 15/04

(54) **Decomposable masking member**

(71) Applicant: NAGOYA OILCHEMICAL CO., LTD., Tokai-shi, Aichi 476 (JP)
(72) Inventor: Horiki, Seinosuke, Minamishibata-cho, Tokai-shi, Aichi 476 (JP); Makino, Reiji, Minamishibata-cho, Tokai-shi, Aichi 476 (JP)
(74) Representative: Senior, Alan Murray

(57) **Abstract**

A decomposable masking member (11, 21, 31, 41) is provided for use in protecting a part of an article (13, 23, 33, 43) from a surface treatment or in providing protection from damage. The masking member is attached to the part of the article and is removed after use. The masking member is decomposable biologically, optically, thermally or the like. In the case of the masking member being biologically decomposable, the removed masking member may be buried in the ground or used as compost. In the case of the masking member being optically decomposable, the removed masking member is irradiated by ultraviolet rays. In the case of the masking member being thermally decomposable, the removed masking member is decomposed by the application of heat. The material of the masking member may be a polymer that is thermally decomposable to its constituent monomer(s) in order that, during heating, the constituent monomer(s) may be collected as the masking member is decomposed.

## Description

The present invention relates to a decomposable masking member suitable for use in protecting a part of an article from a surface treatment such as coating, plating, vacuum evaporation and the like or in providing protection from damage during transportation, storage and the like. In use, the masking member is attached to the part of the article and is removed after use.

Previously masking members have been made of plastics materials, such as polystyrene, polyethylene, polypropylene and the like, or foams thereof, (Jikkai Sho 62-5852). Such masking members have been burnt after use. This has required the provision of an incinerator or the like to burn the masking member and a lot of energy may be wasted during burning. Furthermore, the exhaust gas from the said incinerator or the like can contaminate the atmosphere.

According to one aspect of the present invention there is provided a masking member made of decomposable material. The masking member is preferably biologically decomposable, optically decomposable or thermally decomposable.

When the material is biologically decomposable it is preferred that the material be predominantly (i) a microorganism-decomposable polyester, (ii) carbohydrate or denatured carbohydrate-based, (iii) protein-based, (iv) a naturally occurring material or a denatured naturally occurring material, (v) a mixture of a microorganism and plastics material, (vi) a mixture of plastics material and a microorganism-decomposable material, or (vii) any combination of any of these materials.

Where the material is optically decomposable, the material is, preferably, predominantly an optically decomposable plastics material. The material may, for example, be predominantly (i) a vinyl homopolymer or copolymer, (ii) poly 1,2-butadiene, polyisobutylene oxide, acrylate-oxide methacrylate or the like, (iii) a mixture of an optically decomposable plastics material and an ultraviolet absorber and/or photosensitizer, or (iv) any combination of any of these materials.

Where the material is thermally decomposable, the material is, preferably, predominantly a polymer that is thermally decomposable to its constituent monomer(s). For example, the material may be predominantly polyacrylate, polymethacrylate, polyalkylmethacrylate or polyalkylacrylate.

The material of the masking member may be foamed or molded, preferably into a shape to conform with a part of a surface to be masked by the masking member.

According to a further aspect of the present invention there is provided a method of protecting a part of a surface from surface treatment or damage, the method comprising applying to the part a decomposable masking member of the sort described above and, after performing the surface treatment and/or exposure of the surface to risk of damage, removing the masking member from the part and effecting the decomposition of the masking member.

Where the material of the masking member is biologically decomposable, the decomposition of the removed masking member may be effected by being decomposed by microorganisms, by fermentation reaction, or using the masking member as a raw material for compost or similar.

Where the material of the masking member is optically decomposable, the decomposition of the removed masking member may be effected by exposing the masking member to ultraviolet light, for example by exposing the masking member to the sun or by treating it with ultraviolet light in a decomposition chamber.

Where the material of the masking member is thermally decomposable the decomposition of the removed masking member is effected by heating the masking member. Where the material is predominantly a polymer that is thermally decomposable to its constituent monomer(s), the constituent monomer(s) may, advantageously, be collected during heating of the masking member. For example, the material of the masking member may be predominantly a foamed polybutylmethacrylate such that, on heating the removed masking member, butylmethacrylate monomer may be collected using a condenser.

From the hereinafter described embodiments of masking member in accordance with the present invention it will be appreciated that the present invention provides masking members which are treatable without the use of large equipment or large amounts of energy and which provide little or no atmospheric contamination when being disposed of after use.

Embodiments of decomposable masking member in accordance with the present invention will now be described, by way of example only, with reference to the accompanying drawings, in which:
Fig. 1 is a perspective view of a first embodiment of decomposable masking member;
Fig. 2 is a side-sectional view of the masking member of Fig. 1, in use;
Fig. 3 is a side-sectional view of the masking member of Fig. 1 on removal, after use;
Fig. 4 is a perspective view of a second embodiment of decomposable masking member;
Fig. 5 is a side-sectional view of the masking member of Fig. 4, in use;
Fig. 6 is a perspective view of a third embodiment of decomposable masking member;
Fig. 7 is a side-sectional view of the masking member of Fig. 6, in use;
Fig. 8 is a perspective view of a fourth embodiment of decomposable masking member; and
Fig. 9 is a side-sectional view of the masking member of Fig. 8, in use.

The illustrated embodiments of decomposable masking member are intended to be attached to a part of an article to be protected from a surface treatment or the like and, after the treatment, to be removed from the part. In the case of the masking member being biologically decomposable, the removed masking member may then, for example, be buried in the ground or used as compost. In the case of the masking member being optically decomposable, the removed masking member may, for example, then be exposed to the sun or irradiated by ultraviolet rays and the like. In the case of the masking member being thermally decomposable, the removed masking member may then be decomposed by the application of heat.

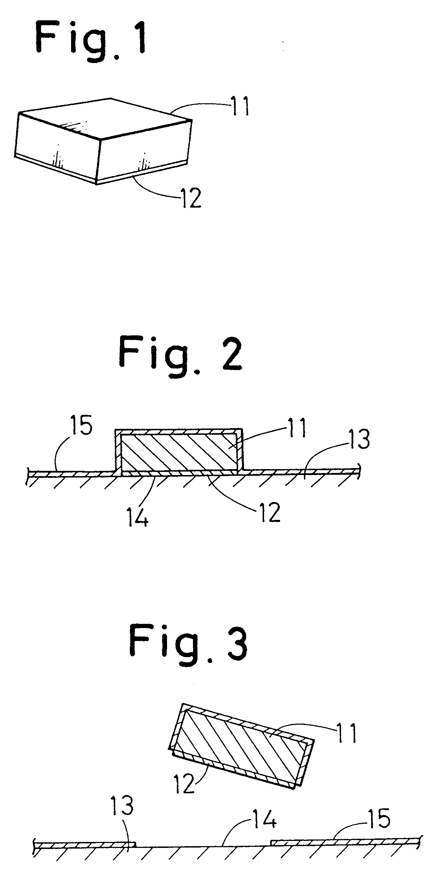

Figs. 1 to 3 show a first embodiment of masking member in accordance with the present invention. The masking member 11 of this embodiment is generally box-shaped and may, for example, be made by molding a flour compound. A pressure sensitive adhesive layer 12 is formed on the underside of the masking member 11 and, as shown in Fig. 2, the masking member 11 is, in use, attached to a predetermined part 14 of a flat surface 13 of an article by the pressure sensitive adhesive layer 12 before surface treatment of the article. After the application of the surface treatment 15, the masking member 11 is removed from the article 14 and the used masking member 11 may then be buried in the ground to be decomposed by microorganisms or used as a raw material to produce alcohol by fermentation.

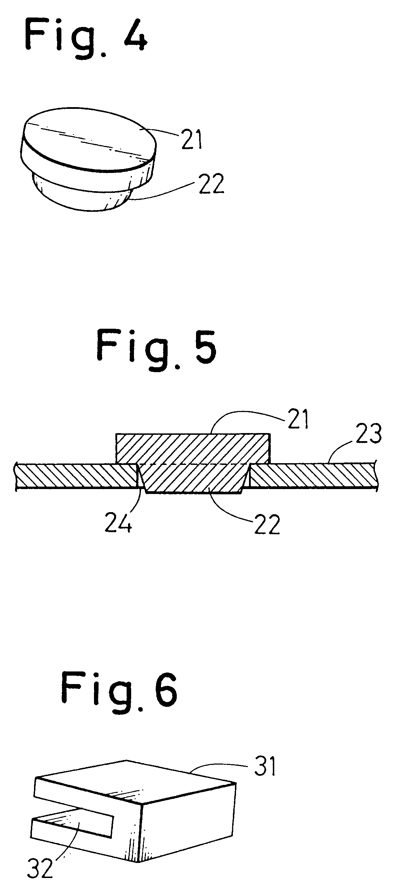

Figs. 4 and 5 show a second embodiment of masking member in accordance with the present invention. The masking member 21 of this embodiment is generally plug-shaped and may, for example, be made of chaff powder molded using a gelatin binder. As shown in Fig. 5, the masking member 21 is mated with a hole 24 portion of an article 23 by inserting on insertion portion 24 of the masking member 21 into the hole 24 to protect the hole from a subsequent surface treatment. After use, the masking member 21 is removed and may then be buried in the ground or used as a raw material for compost.

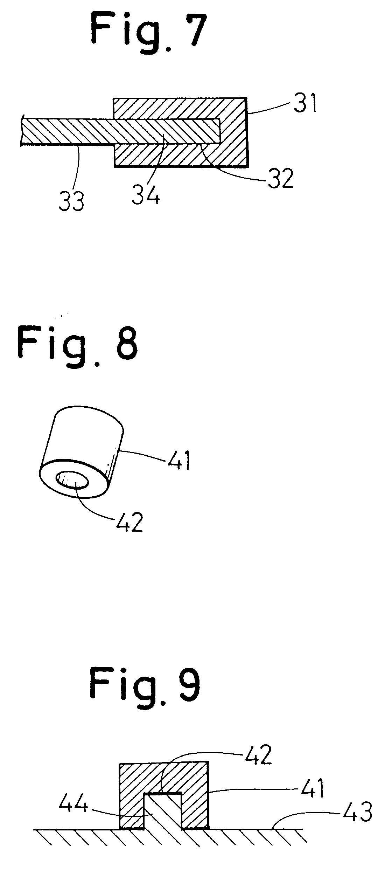

Figs. 6 and 7 show a third embodiment of masking member in accordance with the present invention. The masking member 31 of this embodiment is generally clip-shaped and may, for example, be made of a molded polyisobutylene. As shown in Fig. 7, the masking member 31 is, in use, attached to a predetermined part 34 of a panel 33 of an article by inserting the part 34 of the panel into a channel portion 32 of the masking member 31 so as to protect said part 34 from a subsequent surface treatment. After use, the masking member 31 is removed and may then be exposed to the sun or treated in a decomposition chamber with an ultraviolet lamp.

Figs. 8 and 9 show a fourth embodiment of masking member in accordance with the present invention. The masking member 41 of this embodiment is generally cap-shaped and may, for example, be made of a foamed polybutylmethacrylate. The masking member 41 is , in use, attached to a projection portion 44 of an article 43 by inserting the projection portion 44 into a cavity 42 formed in the masking member 41 to protect the projection portion 44 from a subsequent surface treatment. After use, the masking member 41 is removed and may then be decomposed thermally and the resulting butylmethacrylate monomer collected using a condenser.

Other combinations of masking member shapes and decomposable materials may be successfully employed.

As mentioned above, the masking member of the present invention is made of decomposable material. This material may be decomposed biologically, optically or thermally or be otherwise decomposable. The following are non-limiting examples of suitable materials.

Biologically decomposable material is a microorganism-decomposable polyester such as poly-3-hydroxybutyrate, 3-hydroxyvalerate-3-hydroxybutyrate copolymer, 3-hydroxybutyrate-4-hydroxybutyrate copolymer, 4-hydroxybutyrate-3-hydroxyvalerate copolymer, 3-hydroxybutyric acid-valerianic acid copolymer and the like, carbohydrate or a denaturation carbohydrate such as pullulan, galactose, amylose, dextrin, gum arabic, cellulose, carboxymethylcellulose, methylcellulose, hydroxymethylcellulose, ethylcellulose, acethylcellulose, nitrocellulose, starch, alginic acid and the like, protein such as gelatin, casein, gluten, albumin, soybean protein, glue and the like, natural material or denaturation natural material such as crustacea, chitin, chitosan, chaff, seed crust, plant fiber, animal fiber, bark powder, flour and the like, compound of a microorganism and plastic such as glycolide, polyglycolide, polylactide, polyolefin, poly vinyl chloride, polyacrylate, polyurethane and the like, a compound of said plastic and a material which can be decomposed by a microorganism such as high grade fatty acid, starch, seed crust podwer, linter powder, plant fiber and the like.

Optically decomposable material is homopolymer of a vinyl compound including ketone such as vinyl ketone or the like or a copolymer with other vinyl compound, a material which can be decomposed by light such as an optically decomposable plastic such as poly 1, 2-butadiene, polyisobutylene oxide, acrylate-oxide methacrylate and the like or a compound of a plastic, and anc ultraviolet absorber and/or a photosensitizer and the like.

Thermally decomposable material is such as a polymethacrylate or the like.

## Claims

1. A masking member made of decomposable material.

2. A masking member as claimed in claim 1, wherein the material is biologically decomposable.

3. A masking member as claimed in claim 2, wherein the material is predominantly (i) a microorganism-decomposable polyester, (ii) carbohydrate or denatured carbohydrate-based, (iii) protein-based, (iv) a naturally occurring material or a denatured naturally occurring material, (v) a mixture of a microorganism and plastics material, (vi) a mixture of plastics material and a microorganism-decomposable material, or (vii) any combination of any of these materials.

4. A masking member as claimed in claim 1, wherein the material is optically decomposable.

5. A masking member as claimed in claim 4, wherein the material is predominantly an optically decomposable plastics material.

6. A masking member as claimed in claim 4 or claim 5, wherein the material is predominantly (i) a vinyl homopolymer or copolymer, (ii) poly 1,2-butadiene, polyisobutylene oxide, acrylate-oxide methacrylate or the like, (iii) a mixture of an optically decomposable plastics material and an ultraviolet absorber and/or photosensitizer, or (iv) any combination of any of these materials.

7. A masking member as claimed in claim 1, wherein the material is thermally decomposable.

8. A masking member as claimed in claim 7, wherein the material is predominantly a polymer thermally decomposable to its constituent monomer(s).

9. A masking member as claimed in claim 7 or claim 8, wherein the material is predominantly polyacrylate, polymethacrylate, polyalkylmethacrylate or polyalkylacrylate.

10. A masking member as claimed in any of the preceding claims, wherein the material is foamed or molded.

11. A masking member as claimed in claim 10, wherein the material is foamed or molded into a shape to conform with a part of a surface to be masked by the masking member.

12. The use in protecting part of a surface of a masking member according to any of the preceding claims.

13. A method of protecting a part of a surface from surface treatment or damage, comprising applying a masking member according to any of claims 1 to 11 to the part and, after performing the surface treatment and/or exposure of the surface to risk of damage, removing the masking member from the part and effecting the decomposition of the masking member.

14. A method as claimed in claim 13, when dependent on claim 2 or claim 3, wherein the decomposition of the removed masking member is effected by being decomposed by microorganisms, by fermentation reaction, or using the masking member as a raw material for compost or similar.

15. A masking member as claimed in claim 13 when dependent on any of claims 4 to 6, wherein the decomposition of the removed masking member is effected by exposing the masking member to ultraviolet light.

16. A method as claimed in claim 13 when dependent on any of claims 7 to 9, wherein the decomposition of the removed masking member is effected by heating the masking member.

17. A method as claimed in claim 13, when dependent on claim 8, wherein the decomposition of the removed masking member is effected by heating the masking member and collecting the constituent monomer(s).

18. A method as claimed in claim 17, wherein the material of the masking member is predominantly a foamed polybutylmethacrylate and wherein, on heating the removed masking member, butylmethacrylate monomer is collected using a condenser.
